(19) Europäisches Patentamt / European Patent Office / Office européen des brevets

(11) **EP 4 782 583 A1**

(12) **EUROPEAN PATENT APPLICATION**
published in accordance with Art. 153(4) EPC

(43) Date of publication:
**29.07.2026 Bulletin 2026/31**

(21) Application number: **25758028.2**

(22) Date of filing: **03.02.2025**

(51) International Patent Classification (IPC):
*D03D 15/267* (2021.01)   *C08J 5/24* (2006.01)
*D03D 1/00* (2006.01)   *H05K 1/03* (2006.01)

(52) Cooperative Patent Classification (CPC):
**C08J 5/24; D03D 1/00; D03D 15/267; H05K 1/03**

(86) International application number:
**PCT/JP2025/003475**

(87) International publication number:
**WO 2025/177816 (28.08.2025 Gazette 2025/35)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:   **22.02.2024   JP 2024025172**

(71) Applicant: **Nitto Boseki Co., Ltd.
Fukushima-shi,
Fukushima 960-8161 (JP)**

(72) Inventors:
• **USAMI, Hiroki
  Fukushima-shi, Fukushima 960-2154 (JP)**
• **AWANO, Masahiro
  Fukushima-shi, Fukushima 960-2154 (JP)**

(74) Representative: **Schön, Christoph
Dr. Schön, Neymeyr & Partner mbB
Bavariaring 26
80336 München (DE)**

(54) **GLASS CLOTH, PREPREG, AND PRINTED CIRCUIT BOARD**

(57)   Provided is a glass cloth that can reduce skew when used for a printed wiring board. The glass cloth of the present invention is a glass cloth including glass fibers as warp and weft, wherein a ratio $\sigma t/\sigma y$ of a standard deviation $\sigma t$ of a glass strand thickness of the warp to a standard deviation $\sigma y$ of a glass strand thickness of the weft of the glass cloth is within a range of 0.3 to 0.9.

## Description

Technical Field

The present invention relates to a glass cloth, a prepreg, and a printed wiring board (also referred to as a printed circuit board).

Background Art

A propagation speed of a transmission line formed on a printed wiring board is typically affected by a dielectric constant of a substrate therearound. For example, the propagation speed is represented by the following expression in a case of a microstrip line.

$$V = C/\varepsilon_{\text{eff}}^{1/2}$$

In the formula, C represents the velocity of light, and $\varepsilon_{\text{eff}}$ represents an effective dielectric constant of a substrate.
Data communication technology with large capacity and high speed has been demanded in recent years due to development of electronic devices, and reduction in a delay time difference (skew) between differential wiring also becomes important for increasing the communication speed.
Since a prepreg containing glass cloth used for the printed wiring board has a different dielectric property between glass and a resin, sparseness and denseness of the resin and the glass cloth affect transmission of communication signals. For example, when differential traces are arranged, respectively, in a sparse portion of the glass and in a dense portion of the glass, signal skew occurs in the transmission signals between the traces due to the different effective dielectric constants to cause a problem of deterioration in the transmission property.
As a method for improving the sparseness and denseness of the glass cloth to reduce the skew, conventionally known is a technique of opening the glass cloth and reducing gap in the glass cloth to uniformize the density of glass (see Patent Literature 1, for example).

Citation List

Patent Literature

Patent Literature 1: Japanese Patent Laid-Open No. 2006-232952

Summary of Invention

Technical Problem

However, it needs to convey the glass cloth with applying tension to warp of the glass cloth in order to stably perform the opening treatment of the glass cloth, and thus, the warp is hard to be opened compared with weft. When the differential traces are arranged in the warp direction, the effect by sparseness and denseness of the glass fiber tends to occur, and when the glass cloth has thickness to some extent, the effect by sparseness and denseness of the glass fiber tends to be obvious. Therefore, there is inconvenience in which the printed wiring board using the prepreg containing the glass cloth has large skew.
An object of the present invention is to solve the above inconvenience and to provide glass cloth that can reduce skew when used for a printed wiring board.

Solution to Problem

The present inventors have intensively investigated a means for reducing the skew of the printed wiring board using the prepreg containing glass cloth, and consequently found that the skew of the printed wiring board can be reduced by setting variation of strand thicknesses of warp and weft to be within a certain range even when the warp cannot be sufficiently opened compared with the weft. It is presumed that reducing the variation in thicknesses of warp hard to be opened and allowing the thicknesses of weft to vary to a certain extent allow the glass fiber to be appropriately distributed to enable prevention of a locally dense state, but the present invention is not limited by this presumption.
To achieve the above object, the glass cloth of the present invention is a glass cloth comprising glass fibers as warp and weft, wherein a ratio $\sigma t/\sigma y$ of a standard deviation $\sigma t$ of a glass strand thickness of the warp to a standard deviation σy of a glass strand thickness of the weft of the glass cloth is within a range of 0.3 to 0.9.

In the glass cloth of the present invention, the ratio σt/σy of the standard deviation σt of the glass strand thickness of the warp to the standard deviation σy of the glass strand thickness of the weft of the glass cloth is within the above range, and the skew of the printed wiring board can be consequently reduced.

In the glass cloth of the present invention, if the ratio σt/σy of the standard deviation σt of the glass strand thickness of the warp to the standard deviation σy of the glass strand thickness of the weft of the glass cloth is more than 0.9, the skew of the printed wiring board cannot be reduced. Meanwhile, in the glass cloth of the present invention, it is technically difficult to set the ratio σt/σy of the standard deviation σt of the glass strand thickness of the warp to the standard deviation σy of the glass strand thickness to be less than 0.3.

The glass cloth of the present invention preferably has an opening area rate S within a range of 90 to 100%, wherein the opening area rate S is determined by the following formula (1) from a weaving density Wt of the warp, an average yarn width Bt of the warp, a weaving density Wy of the weft, and an average yarn width By of the weft.
(Expression 1)

$$S = \frac{\left(\frac{25000}{Wt}\right) \times \left(\frac{25000}{Wy}\right) - \left(\left(\frac{25000}{Wt}\right) - Bt\right) \times \left(\left(\frac{25000}{Wy}\right) - By\right)}{\left(\frac{25000}{Wt}\right) \times \left(\frac{25000}{Wy}\right)} \times 100 \qquad \cdot \cdot \cdot (1)$$

In the glass cloth of the present invention, the opening area rate S is within the above range, and the skew of the printed wiring board can be consequently more reduced.

The glass cloth of the present invention preferably has a ratio Rt/Ry within a range of 0.3 to 0.9, wherein Rt/Ry is a ratio of a maximum-minimum difference Rt being a difference between a maximum value and a minimum value of the glass strand thickness of the warp to a maximum-minimum difference Ry being a difference between a maximum value and a minimum value of the glass strand thickness of the weft.

In the glass cloth of the present invention, the ratio Rt/Ry is within the above range, and the skew of the printed wiring board can be further reduced.

The glass cloth of the present invention preferably has a yarn width opening rate Lt of the warp determined by the following formula (2) within a range of 60 to 83%, and preferably has a yarn width opening rate Ly of the weft determined by the following formula (3) within a range of, for example, 85% or more.
(Expression 2)

$$Lt = \frac{Bt}{\left(\frac{25000}{Wt}\right)} \times 100 \qquad \cdot \cdot \cdot (2)$$

(Expression 3)

$$Ly = \frac{By}{\left(\frac{25000}{Wy}\right)} \times 100 \qquad \cdot \cdot \cdot (3)$$

In the glass cloth of the present invention, even when the yarn width opening rate Lt of the warp and the yarn width opening rate Ly of the weft are respectively within the above ranges, the skew of the printed wiring board can be reduced.

Further, the glass cloth of the present invention preferably has a thickness within a range of 18 to 100 μm. In the glass cloth of the present invention, even when the thickness is within the above range, the skew of the printed wiring board can be reduced.

The prepreg of the present invention comprises the glass cloth of the present invention. The prepreg of the present invention can reduce the skew of the printed wiring board by containing the glass cloth of the present invention.

In this case, in the prepreg of the present invention, a difference between a relative dielectric constant of the glass cloth and a relative dielectric constant of a matrix resin of the prepreg is preferably within a range of 1.5 to 3.0. In the prepreg of the present invention, even when the difference between the relative dielectric constant of the glass cloth and the relative dielectric constant of the matrix resin of the prepreg is within the range of 1.5 to 3.0, the effect on transmission of communication signals caused by sparseness and denseness of the resin and the glass cloth in the printed wiring board can be reduced.

The printed wiring board of the present invention comprises the prepreg of the present invention. The printed wiring board of the present invention can reduce the skew by containing the prepreg of the present invention.

Description of Embodiments

Next, embodiments of the present invention will be described in further detail.

The glass cloth of the present embodiment is a glass cloth having glass fibers as warp and weft, and the glass fibers are glass strands composed of a plurality of glass filaments.

In the glass cloth of the present embodiment, a ratio $\sigma t/\sigma y$ of a standard deviation $\sigma t$ of a glass strand thickness of the warp to a standard deviation $\sigma y$ of a glass strand thickness of the weft of the glass cloth is within a range of 0.3 to 0.9, preferably within a range of 0.35 to 0.85, more preferably within a range of 0.35 to 0.71, further preferably within a range of 0.5 to 0.71, and most preferably within a range of 0.6 to 0.71. The glass strand thickness of the weft and the glass strand thickness of the warp of the glass cloth can be measured by a method described later.

In the glass cloth of the present embodiment, an opening area rate S determined by the following formula (1) from a weaving density Wt of the warp, an average yarn width Bt of the warp, a weaving density Wy of the weft, and an average yarn width By of the weft is preferably within a range of 90 to 100%. The yarn widths of the warp and the weft of the glass cloth can be measured by a method described later, and the average yarn width Bt of the warp and the average yarn width By of the weft can be calculated from the yarn widths of the warp and the weft respectively measured.
(Expression 4)

$$S = \frac{\left(\frac{25000}{Wt}\right) \times \left(\frac{25000}{Wy}\right) - \left(\left(\frac{25000}{Wt}\right) - Bt\right) \times \left(\left(\frac{25000}{Wy}\right) - By\right)}{\left(\frac{25000}{Wt}\right) \times \left(\frac{25000}{Wy}\right)} \times 100 \quad \cdot\cdot\cdot(1)$$

The opening area rate S is more preferably within a range of 95 to 100%, further preferably within a range of 96 to 99.9%, and most preferably within a range of 98.5 to 99.9%.

The weaving density Wt of the warp and the weaving density Wy of the weft are not particularly limited, and may be each within a range of 20 to 120 yarn/25-mm. The weaving density Wt of the warp and the weaving density Wy of the weft may be densities different from each other. The weaving density Wt of the warp is more preferably within a range of 30 to 110 yarn/25-mm, further preferably within a range of 40 to 100 yarn/25-mm, and most preferably within a range of 50 to 70 yarn/25-mm. The weaving density Wy of the weft is more preferably within a range of 30 to 110 yarn/25-mm, further preferably within a range of 40 to 100 yarn/25-mm, and most preferably within a range of 50 to 70 yarn/25-mm.

In the glass cloth of the present embodiment, a ratio Rt/Ry is preferably within a range of 0.3 to 0.9, wherein Rt/Ry is a ratio of a maximum-minimum difference Rt being a difference between a maximum value and a minimum value of the glass strand thickness of the warp to a maximum-minimum difference Ry being a difference between a maximum value and a minimum value of the glass strand thickness of the weft.

The ratio Rt/Ry is more preferably within a range of 0.4 to 0.9, further preferably within a range of 0.4 to 0.8, and most preferably within a range of 0.6 to 0.7.

In the glass cloth of the present embodiment, a yarn width opening rate Lt of the warp determined by the following formula (2) is preferably within a range of 60 to 83%, and a yarn width opening rate Ly of the weft determined by the following formula (3) is preferably within a range of 85% or more.
(Expression 5)

$$Lt = \frac{Bt}{\left(\frac{25000}{Wt}\right)} \times 100 \quad \cdot\cdot\cdot(2)$$

(Expression 6)

$$Ly = \frac{By}{\left(\frac{25000}{Wy}\right)} \times 100 \quad \cdot\cdot\cdot(3)$$

The yarn width opening rate Lt of the warp is more preferably within a range of 63 to 83%, further preferably within a range of 63 to 75%, and most preferably within a range of 63 to 68%. The yarn width opening rate Ly of the weft is more preferably within a range of 88% or more, further preferably within a range of 90% or more, and most preferably within a range of 95% or more.

The yarn width opening rate Lt of the warp and the yarn width opening rate Ly of the weft can be respectively calculated from the yarn widths of the warp and the weft measured by a method described later.

The glass cloth of the present embodiment preferably has a thickness within a range of 18 to 100 $\mu$m. The thickness of the glass cloth of the present embodiment is more preferably within a range of 25 to 90 $\mu$m, further preferably within a range of 30 to 80 $\mu$m, and most preferably within a range of 30 to 50 $\mu$m.

The thickness of the glass cloth is an average value of measurement values when the thickness is measured at 15 points in the glass cloth with a micrometer in accordance with JIS R 3420:2013.

The glass cloth of the present embodiment is woven with the glass fiber (the glass strand) as warp and weft, and can be manufactured as follows, for example.

First, a predetermined glass batch (a glass raw material) is melted and subjected to fibrillization to obtain a glass filament. A filament diameter of the glass filament is not particularly limited, but preferably within a range of 10 $\mu$m or less, more preferably within a range of 8 $\mu$m or less, and particularly preferably within a range of 3 to 7 $\mu$m for application of the printed wiring board.

Within a range of, for example, 25 to 500, preferably within a range of 40 to 300, of the glass filaments are bundled by a known method to form the glass fiber. Note that, a method of melting and subjecting the glass batch to fibrillization to obtain the glass filament, and then bundling a plurality of the glass filaments to obtain the glass fiber (the glass strand) is called spinning.

A mass per unit length of the glass fiber (the glass strand) is preferably within a range of 2 to 30 g/1000-m, more preferably within a range of 4 to 25 g/1000-m, and further preferably within a range of 4 to 15 g/1000-m.

Glass composition of the glass fiber is not particularly limited, and examples thereof include E-glass composition, high-strength and high-elasticity glass composition, high-elasticity and easily-manufacturing glass composition, or low-dielectric-constant and low-dielectric-loss-tangent glass composition. For the high-speed communication application, the low-dielectric-constant and low-dielectric-loss-tangent glass composition is preferable, and examples thereof include NE glass, L glass, or D glass.

The E-glass composition is the most generic glass composition, and contains $SiO_2$ in a range of 52.0 to 56.0 mass%, $Al_2O_3$ in a range of 12.0 to 16.0 mass%, MgO and CaO in a range of 20.0 to 25.0 mass% in total, and $B_2O_3$ in a range of 5.0 to 10.0 mass% relative to the total amount of the glass fiber.

The high-strength and high-elasticity glass composition contains $SiO_2$ in a range of 60.0 to 70.0 mass%, $Al_2O_3$ in a range of 20.0 to 30.0 mass%, MgO in a range of 5.0 to 15.0 mass%, $Fe_2O_3$ in a range of 0 to 1.5 mass%, and $Na_2O$, $K_2O$, and $Li_2O$ in a range of 0 to 0.2 mass% in total relative to the total amount of the glass fiber. The high-strength and high-elasticity glass composition preferably contains $Fe_2O_3$ in a range of 0.15 to 1.50 mass%, $ZrO_2$ in a range of 0.01 to 0.10 mass%, and $Na_2O$, $K_2O$, and $Li_2O$ in a range of 0.02 to 0.20 mass% in total.

The high-elasticity and easily-manufacturing glass composition contains $SiO_2$ in a range of 57.0 to 60.0 mass%, $Al_2O_3$ in a range of 17.5 to 20.0 mass%, MgO in a range of 8.5 to 12.0 mass%, CaO in a range of 10.0 to 13.0 mass%, and $B_2O_3$ in a range of 0.5 to 1.5 mass% relative to the total amount of the glass fiber, and contains $SiO_2$, $Al_2O_3$, MgO, and CaO in a range of 98.0 mass% or more in total.

The low-dielectric-constant and low-dielectric-loss-tangent glass composition contains $SiO_2$ in a range of 48.0 to 62.0 mass%, $B_2O_3$ in a range of 17.0 to 26.0 mass%, $Al_2O_3$ in a range of 9.0 to 18.0 mass%, CaO in a range of 0.1 to 9.0 mass%, MgO in a range of 0 to 6.0 mass%, $Na_2O$, $K_2O$, and $Li_2O$ in a range of 0 to 0.5 mass% in total, $TiO_2$ in a range of 0 to 5.0 mass%, SrO in a range of 0 to 6.0 mass%, $F_2$ and $Cl_2$ in a range of 0 to 3.0 mass% in total, and $P_2O_5$ in a range of 0 to 6.0 mass% relative to the total amount of the glass fiber.

A content of each component in the aforementioned glass composition can be measured by using an ICP emission spectrometer for Li, which is a light element, and can be measured by using a wavelength dispersive fluorescent X-ray analyzer for the other elements. The content of each component in the glass composition can be specifically measured as follows.

First, the glass cloth is cut into an appropriate size, then put into a platinum crucible, and the mixture is melted in an electric furnace while holding the temperature at 1400 to 1650°C for 6 hours and stirring to obtain homogeneous melted glass. Here, when an organic substance adheres to the glass cloth surface or when the glass fiber is contained in an organic substance (resin) as mainly a reinforcing material, the organic substance is removed for use by, for example, heating in a muffle furnace at 300 to 650°C for about 2 to 24 hours.

Then, the obtained melted glass is flowed on a carbon plate to produce a glass cullet, and the cullet is crushed and then powdered into glass powder. Li, which is a light element, is quantitatively analyzed by using the ICP emission spectrometer after the glass powder is thermally decomposed with an acid. The other elements are quantitatively analyzed by using the wavelength dispersive fluorescent X-ray analyzer after the glass powder is formed into a disk shape with a pressing machine.

The quantitative analysis using the wavelength dispersive fluorescent X-ray analyzer can be performed by the following method. First, the content of each component in a sample for measurement is measured by a fundamental parameter method. Then, based on this measurement result, at least three samples for a calibration curve are produced, and the analysis is performed by a calibration curve method. The content of each component in the samples for a calibration curve can be quantitatively analyzed with the ICP emission spectrometer. Then, these quantitative analysis results are converted as an oxide to calculate the content of each component and the total amount, and from these values, the aforementioned content rate (mass%) of each component can be determined.

Then, the glass fiber (the glass strand) is woven as warp or weft by using a known loom to obtain the glass cloth of the present embodiment. Examples of the loom include a jet-type loom such as air jet or water jet, a shuttle-type loom, and a rapier loom. Examples of a weaving method with the loom include plain weaving, satin weaving, basket weaving, and twill weaving, and plain weaving is preferable from the viewpoint of manufacturing efficiency.

In the weaving, a sizing agent can be used in order to bundle the glass filaments and to protect the glass fiber (the glass strand). Examples of the sizing agent include sizing agents in which a coating-forming component is starch-based or polyvinyl alcohol (PVA)-based. The sizing agent may contain an oil agent, a softening agent, etc.

In the glass cloth of the present embodiment, an adhering amount of the sizing agent relative to 100 parts by mass of the glass fiber yarn is preferably within a range of 0.1 to 5 parts by mass, more preferably within a range of 0.3 to 3 parts by mass, and further preferably within a range of 0.5 to 2 parts by mass.

The glass cloth of the present embodiment may be subjected to an opening treatment and further subjected to a deoiling treatment and a surface treatment after the weaving. Any of the opening treatment, the deoiling treatment, and the surface treatment may be performed first, and the order is not limited.

Examples of the opening treatment include a treatment of increasing yarn widths of the warp and the weft by performing: a treatment (a highly pressurized water opening treatment) of opening with a pressure of fluid such as water jet having a surface pressure within a range of 1 to 8 MPa while applying tension to the warp of the glass cloth of the present embodiment within a range of 30 to 500 N; a treatment of opening with water flow pressure such as a generic spray; a treatment of opening with high-frequency vibration such as ultrasonic wave though liquid as a medium; a treatment of opening with pressurizing with a roll; etc.

Examples of the deoiling treatment include a treatment in which the glass cloth of the present embodiment is arranged in a heating furnace at an atmospheric temperature within a range of 300 to 500°C for a time within a range of 40 to 80 hours to thermally decompose the organic substance adhering to the glass fiber.

Examples of the surface treatment include a treatment in which the glass cloth is immersed in a solution containing a silane coupling agent or containing the silane coupling agent and a surfactant, excess water is squeezed, and then the glass cloth is heated and dried at a temperature within a range of 90 to 120°C for a time within a range of 1 to 10 minutes.

Examples of the silane coupling agent include an aminosilane, an ureidosilane, a chlorosilane, an epoxysilane, a mercaptosilane, a vinylsilane, a (meth)acrylsilane, a phenylsilane, a styrylsilane, and an isocyanatesilane. In the present embodiment, the silane coupling agent may be used singly, or may be used in combination of two or more thereof.

Examples of the aminosilane include γ-aminopropyltriethoxysilane, N-β-(aminoethyl)-γ-aminopropyltrimethoxysilane, N-β-(aminoethyl)-N'-β-(aminoethyl)-y-aminopropyltrimethoxysilane, and γ-anilinopropyltrimethoxysilane.

Examples of the ureidosilane include γ-ureidopropyltriethoxysilane.

Examples of the chlorosilane include γ-chloropropyltrimethoxysilane.

Examples of the epoxysilane include β-(3,4-epoxycyclohexyl)ethyltrimethoxysilane and γ-glycidoxypropyltrimethoxysilane.

Examples of the mercaptosilane include γ-mercaptotrimethoxysilane and γ-mercaptopropyltrimethoxysilane.

Examples of the vinylsilane include vinyltrimethoxysilane, N-β-(N-vinylbenzylaminoethyl)-γ-aminopropyltrimethoxysilane, and N-benzyl-β-aminoethyl-γ-aminopropyltrimethoxysilane.

Examples of the (meth)acrylsilane include γ-acryloxypropyltrimethoxysilane and γ-methacryloxypropyltrimethoxysilane.

Examples of the phenylsilane include phenyltrimethoxysilane.

Examples of the styrylsilane include p-styryltrimethoxysilane.

Examples of the isocyanatesilane include γ-isocyanatepropyltriethoxysilane.

Examples of the surfactant include a nonionic surfactant, a cationic surfactant, an anionic surfactant, and an amphoteric surfactant. In the present embodiment, the surfactant may be used singly, or may be used in combination of two or more thereof.

Examples of the nonionic surfactant include an ethylene-oxide propylene-oxide alkyl ether, a polyoxyethylene alkyl ether, a polyoxyethylene-polyoxypropylene block copolymer, an alkylpolyoxyethylene-polyoxypropylene block copolymer ether, a polyoxyethylene fatty acid ester, a polyoxyethylene fatty acid monoester, a polyoxyethylene fatty acid diester, a polyoxyethylene sorbitan fatty acid ester, a glycerol fatty acid ester ethylene oxide adduct, a polyoxyethylene castor oil ether, a hardened castor oil ethylene oxide adduct, an alkylamine ethylene oxide adduct, a fatty acid amide ethylene oxide adduct, a glycerol fatty acid ester, a polyglycerol fatty acid ester, a pentaerythritol fatty acid ester, a sorbitol fatty acid ester, a sorbitan fatty acid ester, a sucrose fatty acid ester, a polyhydric alcohol alkyl ether, a fatty acid alkanolamide, acetylene glycol, acetylene alcohol, an ethylene oxide adduct of acetylene glycol, and an ethylene oxide adduct of acetylene alcohol.

Examples of the cationic surfactant include an alkyldimethylbenzylammonium chloride, an alkyltrimethylammonium chloride, an alkyldimethylethylammonium ethylsulfate, a higher alkylamine salt (such as an acetate salt and a hydrochloric acid salt), an ethylene oxide adduct to a higher alkylamine, a condensate between a higher fatty acid and a polyalkylene polyamine, a salt of an ester between a higher fatty acid and an alkanolamine, a salt of a higher fatty acid amide, an imidazoline-type cationic surfactant, and an alkylpyridinium salt.

Examples of the anionic surfactant include a higher alcohol sulfate ester salt, a higher alkyl ether sulfate ester salt, an α-olefin sulfate ester salt, an alkylbenzenesulfonate salt, an α-olefin sulfonate salt, a reaction product between a fatty acid halide and N-methyltaurine, a sulfosuccinic acid dialkyl ester salt, a higher alcohol phosphate ester salt, and a phosphate ester salt of a higher alcohol ethylene oxide adduct.

Examples of the amphoteric surfactant include an amino-acid-type amphoteric surfactant such as an alkylaminopropionate alkali metal salt, a betaine-type amphoteric surfactant such as an alkyldimethylbetaine, and an imidazoline-type amphoteric surfactant.

Next, the prepreg of the present embodiment can be obtained by impregnating at least a part of the glass cloth of the present embodiment with a resin by a known method, and semi-curing the resin.

In the prepreg of the present embodiment, a difference between a relative dielectric constant of the glass cloth of the present embodiment and a relative dielectric constant of the matrix resin of the prepreg is preferably within a range of 1.5 to 3.0, more preferably within a range of 1.6 to 2.8, further preferably within a range of 1.7 to 2.6, and particularly preferably within a range of 1.9 to 2.5.

When the glass fiber (the glass strand) has glass composition such as the E-glass composition, the high-strength and high-elasticity glass composition, the high-elasticity and easily-manufacturing glass composition, or the low-dielectric-constant and low-dielectric-loss-tangent glass composition, the relative dielectric constant of the glass cloth of the present embodiment is within a range of 3.0 to 7.0, preferably within a range of 3.5 to 6.0, and further preferably within a range of 4.0 to 5.0 at a measurement frequency of 10 GHz.

In this time, examples of the matrix resin that allows the difference with the relative dielectric constant of the glass cloth of the present embodiment to be within the above range include an epoxy resin, a polyphenylene ether resin, a maleimide resin, a cycloolefin polymer resin, and an ODV resin. The matrix resin is preferably a thermosetting resin with a low dielectric property for the high-speed communication application, and examples of such a thermosetting resin include modified polyphenylene ether or reactive low-molecular-weight polyphenylene ether.

Next, the printed wiring board of the present embodiment can be obtained by curing the prepreg of the present embodiment, stacking a plurality of the cured prepregs, overlapping copper foil such as, for example, low-roughness electrolytic copper foil above and under the cured prepregs and hot-pressing the stacked body to form a copper-clad laminate, and then patterning the copper foil to form a predetermined wiring pattern. The patterning can be performed by a known method such as photolithography.

Next, Examples and Comparative Examples of the present invention will be described.

Examples

(Example 1)

In this Example, by using a glass fiber (a glass strand) composed by bundling 200 glass filaments having low-dielectric-constant low-dielectric loss tangent glass composition and having a relative dielectric constant of 4.7 (measurement frequency: 10 GHz) as warp and weft, produced was a glass cloth corresponding to IPC4412 standard #1078 (used yarn: D500 (fiber diameter: 5.0 μm, yarn weight: 10.1 g/1000-m), warp weaving density: 53 yarn/25-mm, weft weaving density: 53 yarn/25-mm, weight per unit area: 43 g/m$^2$).

Used for the warp of the glass cloth was yarn in which a glass-fiber protecting agent (a sizing agent) was applied in a warping step, and then the warp is pressed against a drum-type cylinder having a surface at a temperature held at 120°C to be dried.

Then, the produced glass cloth was subjected to a deoiling treatment by heating at a temperature of 450°C for 60 hours, then subjected to a water-pressure opening treatment with a jet spray at a water pressure of 6.0 MPa, the opened glass cloth was subjected to a surface treatment by immersion in a glass treating agent aqueous solution in which 3-methacryloxypropyltrimethoxysilane (manufactured by Dow Corning Toray Co., Ltd., trade name: OFS6030) and acetic acid were dispersed in water, and heating and drying to obtain a surface-treated opened glass cloth having a thickness of 43.2 μm.

Next, as for the surface-treated opened glass cloth obtained in this Example, yarn widths of the warp and the weft that constituted the surface-treated opened glass cloth were measured by a method described later to calculate an average warp width, an average weft width, an opening area rate S, a warp yarn width opening rate Lt, and a weft yarn width opening rate Ly. Table 1 shows the results.

(Method for measuring yarn width)

As for the surface-treated opened glass cloth obtained in this Example, glass cloth specimens having a size of 110 mm in length × 60 mm in width were cut from three points in the width direction of the glass cloth (portions with 100 mm from both the ends and the center portion) by using a digital microscope (manufactured by KEYENCE CORPORATION) with a magnification of 100, and warp widths and weft widths were continuously measured at 100 points in each of the yarn direction, and from an average value of the 300 measurement points in total, the average warp width and the average weft width were determined.

Then, a surface-treated opened glass cloth specimen obtained by cutting the surface-treated opened glass cloth into a size of 450 mm in length × 400 mm in width was immersed in a modified polyphenylene ether resin vanish, and preliminarily dried at a temperature of 150°C for 10 minutes to obtain a prepreg having a resin content of 60 mass%. The modified polyphenylene ether resin vanish was prepared by adding toluene (manufactured by FUJIFILM Wako Pure Chemical Corporation) as a solvent into 70 parts by mass of reactive low-molecular-weight polyphenylene ether (manufactured by SABIC Corporation, trade name: SA9000, dielectric constant: 2.5 (measurement frequency: 1 MHz)), 30 parts by mass of triallyl isocyanurate (manufactured by Evonik Japan Co., Ltd., trade name: TAICROS), and 1 part by mass of $\alpha,\alpha'$-di(tertiarybutylperoxy)diisopropylbenzene (manufactured by NOF CORPORATION, trade name PERBUTYL P).

Then, two of the prepregs were stacked, low-roughness electrolytic copper foil (manufactured by FUKUDA METAL FOIL & POWDER CO., LTD., trade name: CF-T4X-SV18, thickness: 18 $\mu$m) was overlapped above and under the prepregs, and the stacked body was heated and pressurized by using a vacuum hot-press (manufactured by Kitagawa Seiki Co., Ltd.) at 205°C under a surface pressure condition of 4 MPa in vacuo for 1 hour to obtain a copper-clad laminate having a plate thickness of 0.21 mm.

Then, as for the copper-clad laminate obtained in this Example, strand thicknesses of the warp and the weft of the glass cloth contained in the copper-clad laminate were measured by a method described later to calculate: a ratio $\sigma t/\sigma y$ of a standard deviation $\sigma t$ of the glass strand thickness of the warp to a standard deviation $\sigma y$ of the glass strand thickness of the weft; and a ratio Rt/Ry of a maximum-minimum difference Rt in the glass strand thickness of the warp to a maximum-minimum difference Ry in the glass strand thickness of the weft. Table 1 shows the results.

(Method for measuring strand thickness)

The copper-clad laminate obtained in this Example was cut to a size of 14 mm × 10 mm, embedded by using an epoxy resin (manufactured by CEMEDINE CO., LTD., trade name: 1500), and the cross section was grinded parallel to the warp or weft direction so that an intersection point of the warp and the weft of the glass cloth was exposed to the surface. By using a scanning electron microscope (manufactured by JEOL Ltd., trade name: IT700HR), thicknesses of the continued strands adjacent to each other of the glass cloth contained in the copper-clad laminate were measured at 30 points with a magnification of 300. Here, the thickness of the strand of the warp refers to a distance between lines drawn parallelly to the weft direction from each of the glass filament upper portion positioned at the uppermost portion of the yarn (glass filament) bundle of the warp and the glass filament lower portion positioned at the lowermost portion of the yarn bundle of the warp. Similarly, the thickness of the strand of the weft refers to a distance between lines drawn parallelly to the warp direction from each of the glass filament upper portion positioned at the uppermost portion of the yarn bundle of the weft and the glass filament lower portion positioned at the lowermost portion of the yarn bundle of the weft. The strand thickness was measured at the intersection point of the warp and the weft. That is, when the strand thickness of the warp of the glass cloth was measured, measured was a thickness of a strand in a position where one or more wefts were present above or under the yarn bundle of the warp, and when the strand thickness of the weft of the glass cloth was measured, measured was a thickness of a strand in a position where one or more warps were present above or under the yarn bundle of the weft.

Then, as for a printed wiring board obtained by patterning the copper foil on one surface of the copper-clad laminate obtained in this Example, skew was measured by a method described later, and evaluated. Table 1 shows the results.

(Method for measuring and evaluating skew)

The copper foil on one surface of the copper-clad laminate obtained in this Example was subjected to patterning to form eight pairs of differential microstrip lines parallel to the warp direction of the glass cloth. The wiring width was set to 130 $\mu$m in width. A gap between two lines constituting the differential was set to a distance of 1/2 of a pitch (25000 /Wt) of the warp of the used glass cloth, and each pair of the differential traces was arranged to be shifted in the weft direction with 9/8 of the pitch of the warp. The line arrangement as above can obtain data of skew including a combination of a line with the maximum effective dielectric constant having the maximum glass component directly under the line and a line with the minimum effective dielectric constant having the maximum resin component directly under the line. By using a network analyzer (manufactured by Keysight Technologies, trade name: N5227B), skew corresponding to 100-mm line was measured.

From the results of the measurement, a case where the maximum value of the skew values at the eight points was less than 2.5 ps/100-mm was evaluated as ⊙, a case where the value was 2.5 ps/100-mm or more and less than 3.5 ps/100-mm was evaluated as ○, and a case where the value was 3.5 ps/100-mm or more was evaluated as ×.

(Example 2)

In this Example, a surface-treated opened glass cloth and a copper-clad laminate were obtained in exactly the same manner as in Example 1 except that a glass cloth corresponding to IPC4412 standard #1280 (used yarn: D500 (fiber diameter: 5.0 μm, yarn weight: 10.1 g/1000-m), warp weaving density: 59 yarn/25-mm, weft weaving density: 59 yarn/25-mm, weight per unit area: 48 g/m$^2$) was produced.

Then, in exactly the same manner as in Example 1, the yarn widths of the warp and the weft, the strand thicknesses, and the skew were measured to calculate the average warp width, the average weft width, the opening area rate S, the warp yarn width opening rate Lt, the weft yarn width opening rate Ly, the ratio σt/σy of a standard deviation σt of the glass strand thickness of the warp to a standard deviation σy of the glass strand thickness of the weft, and a ratio Rt/Ry of a maximum-minimum difference Rt in the glass strand thickness of the warp to a maximum-minimum difference Ry in the glass strand thickness of the weft, and to evaluate the skew. Table 1 shows the results.

(Example 3)

In this Example, a surface-treated opened glass cloth and a copper-clad laminate were obtained in exactly the same manner as in Example 1 except that: the glass cloth was produced by using a glass fiber (a glass strand) composed by bundling 200 glass filaments having a relative dielectric constant of 4.5 (measurement frequency: 10 GHz); and the opening treatment was a water pressure opening with a jet spray at a water pressure of 5.0 MPa.

Then, in exactly the same manner as in Example 1, the yarn widths of the warp and the weft, the strand thicknesses, and the skew were measured to calculate the average warp width, the average weft width, the opening area rate S, the warp yarn width opening rate Lt, the weft yarn width opening rate Ly, the ratio σt/σy of a standard deviation σt of the glass strand thickness of the warp to a standard deviation σy of the glass strand thickness of the weft, and a ratio Rt/Ry of a maximum-minimum difference Rt in the glass strand thickness of the warp to a maximum-minimum difference Ry in the glass strand thickness of the weft, and to evaluate the skew. Table 1 shows the results.

(Example 4)

In this Example, a surface-treated opened glass cloth and a copper-clad laminate were obtained in exactly the same manner as in Example 3 except that: a yarn dried without contact in a chamber at a temperature held at 120°C in the warping step was used as the warp of the glass cloth; and the opening treatment was a water pressure opening with a jet spray at a water pressure of 7.0 MPa

Then, in exactly the same manner as in Example 1, the yarn widths of the warp and the weft, the strand thicknesses, and the skew were measured to calculate the average warp width, the average weft width, the opening area rate S, the warp yarn width opening rate Lt, the weft yarn width opening rate Ly, the ratio σt/σy of a standard deviation σt of the glass strand thickness of the warp to a standard deviation σy of the glass strand thickness of the weft, and a ratio Rt/Ry of a maximum-minimum difference Rt in the glass strand thickness of the warp to a maximum-minimum difference Ry in the glass strand thickness of the weft, and to evaluate the skew. Table 1 shows the results.

(Example 5)

In this Example, a surface-treated opened glass cloth and a copper-clad laminate were obtained in exactly the same manner as in Example 1 except that a glass cloth corresponding to IPC4412 standard #2116 (used yarn: E250 (fiber diameter: 7.0 μm, yarn weight: 20.2 g/1000-m), warp weaving density: 59 yarn/25-mm, weft weaving density: 57 yarn/25-mm, weight per unit area: 95 g/m$^2$) was produced.

Then, in exactly the same manner as in Example 1, the yarn widths of the warp and the weft, the strand thicknesses, and the skew were measured to calculate the average warp width, the average weft width, the opening area rate S, the warp yarn width opening rate Lt, the weft yarn width opening rate Ly, the ratio σt/σy of a standard deviation σt of the glass strand thickness of the warp to a standard deviation σy of the glass strand thickness of the weft, and a ratio Rt/Ry of a maximum-minimum difference Rt in the glass strand thickness of the warp to a maximum-minimum difference Ry in the glass strand thickness of the weft, and to evaluate the skew. Table 1 shows the results.

(Comparative Example 1)

In this Comparative Example, a surface-treated glass cloth and a copper-clad laminate were obtained in exactly the same manner as in Example 1 except that the opening treatment was not performed at all.
Then, in exactly the same manner as in Example 1, the yarn widths of the warp and the weft, the strand thicknesses, and the skew were measured to calculate the average warp width, the average weft width, the opening area rate S, the warp yarn width opening rate Lt, the weft yarn width opening rate Ly, the ratio $\sigma t/\sigma y$ of a standard deviation $\sigma t$ of the glass strand thickness of the warp to a standard deviation $\sigma y$ of the glass strand thickness of the weft, and a ratio Rt/Ry of a maximum-minimum difference Rt in the glass strand thickness of the warp to a maximum-minimum difference Ry in the glass strand thickness of the weft, and to evaluate the skew. Table 1 shows the results.
In this Comparative Example, the opening area rate S, the warp yarn width opening rate Lt, and the weft yarn width opening rate Ly were calculated by using yarn widths of warp and weft that were not subjected to the opening treatment.

(Comparative Example 2)

In this Comparative Example, a surface-treated opened glass cloth and a copper-clad laminate were obtained in exactly the same manner as in Example 1 except that the opening treatment of the glass cloth was performed by water pressure opening with a fan-shaped spray at a water pressure of 6.0 MPa.
Then, in exactly the same manner as in Example 1, the yarn widths of the warp and the weft, the strand thicknesses, and the skew were measured to calculate the average warp width, the average weft width, the opening area rate S, the warp yarn width opening rate Lt, the weft yarn width opening rate Ly, the ratio $\sigma t/\sigma y$ of a standard deviation $\sigma t$ of the glass strand thickness of the warp to a standard deviation $\sigma y$ of the glass strand thickness of the weft, and a ratio Rt/Ry of a maximum-minimum difference Rt in the glass strand thickness of the warp to a maximum-minimum difference Ry in the glass strand thickness of the weft, and to evaluate the skew. Table 1 shows the results.

(Comparative Example 3)

In this Comparative Example, a surface-treated opened glass cloth and a copper-clad laminate were obtained in exactly the same manner as in Example 1 except that the opening treatment of the glass cloth was performed with a contactless ultrasonic-wave opening treatment by passing the glass cloth through water liquid vibrated with an ultrasonic-wave vibrator at 60 Hz.
Then, in exactly the same manner as in Example 1, the yarn widths of the warp and the weft, the strand thicknesses, and the skew were measured to calculate the average warp width, the average weft width, the opening area rate S, the warp yarn width opening rate Lt, the weft yarn width opening rate Ly, the ratio $\sigma t/\sigma y$ of a standard deviation $\sigma t$ of the glass strand thickness of the warp to a standard deviation $\sigma y$ of the glass strand thickness of the weft, and a ratio Rt/Ry of a maximum-minimum difference Rt in the glass strand thickness of the warp to a maximum-minimum difference Ry in the glass strand thickness of the weft, and to evaluate the skew. Table 1 shows the results.

(Table 1)

| | Example 1 | Example 2 | Example 3 | Example 4 | Example 5 | Comparative Example 1 | Comparative Example 2 | Comparative Example 3 |
|---|---|---|---|---|---|---|---|---|
| Warp filament diameter ($\mu$m) | 5 | 5 | 5 | 5 | 7 | 5 | 5 | 5 |
| Number of warp filaments | 200 | 200 | 200 | 200 | 200 | 200 | 200 | 200 |
| Weaving density of warp Wt (yarn/25-mm) | 53 | 59 | 53 | 53 | 59 | 53 | 53 | 53 |

(continued)

| | Example 1 | Example 2 | Example 3 | Example 4 | Example 5 | Comparative Example 1 | Comparative Example 2 | Comparative Example 3 |
|---|---|---|---|---|---|---|---|---|
| Weft filament diameter ($\mu$m) | 5 | 5 | 5 | 5 | 7 | 5 | 5 | 5 |
| Number of weft filaments | 200 | 200 | 200 | 200 | 200 | 200 | 200 | 200 |
| Weaving density of weft Wy (yarn/25-mm) | 53 | 59 | 53 | 53 | 57 | 53 | 53 | 53 |
| Cloth thickness ($\mu$m) | 43.2 | 44.5 | 43.3 | 43.0 | 89.9 | 57.0 | 52.0 | 45.5 |
| Relative dielectric constant of glass | 4.7 | 4.7 | 4.5 | 4.5 | 4.7 | 4.7 | 4.7 | 4.7 |
| Relative dielectric constant of resin | 2.5 | 2.5 | 2.5 | 2.5 | 2.5 | 2.5 | 2.5 | 2.5 |
| Average yam width of warp Bt ($\mu$m) | 334 | 301 | 300 | 304 | 350 | 189 | 224 | 396 |
| Average yam width of weft By ($\mu$m) | 463 | 419 | 453 | 451 | 418 | 323 | 465 | 432 |
| Average thickness of warp strand ($\mu$m) | 25.8 | 30.5 | 29.3 | 26.4 | 55.6 | 40.5 | 39.3 | 26.6 |
| Maximum value of warp strand thickness ($\mu$m) | 28.3 | 34.4 | 32.2 | 31.0 | 57.8 | 47.8 | 47.7 | 29.3 |
| Minimum value of warp strand thickness ($\mu$m) | 23.4 | 28.2 | 25.2 | 22.7 | 53.2 | 33.2 | 34.0 | 23.2 |

(continued)

|  | Example 1 | Example 2 | Example 3 | Example 4 | Example 5 | Comparative Example 1 | Comparative Example 2 | Comparative Example 3 |
|---|---|---|---|---|---|---|---|---|
| Maximum-minimum difference in warp strand thickness Rt (µm) | 4.8 | 6.2 | 6.9 | 8.3 | 4.6 | 14.6 | 13.8 | 6.1 |
| Standard deviation of warp strand thickness σt (um) | 1.48 | 1.62 | 1.70 | 2.05 | 1.03 | 3.58 | 3.05 | 1.98 |
| Average thickness of weft strand (um) | 20.3 | 23.6 | 20.3 | 19.3 | 49.5 | 29.6 | 241 | 22.9 |
| Maximum value of weft strand thickness (µm) | 24.6 | 28.3 | 26.7 | 24.1 | 54 1 | 35.6 | 30.3 | 26.6 |
| Minimum value of weft strand thickness (µm) | 17.4 | 18.9 | 15.4 | 14.4 | 44.0 | 25.1 | 19.3 | 20.2 |
| Maximum-minimum difference in weft strand thickness Ry (µm) | 7.3 | 9.5 | 11.3 | 9.6 | 10.1 | 10.5 | 11.0 | 6.4 |
| Standard deviation of weft strand thickness (σy (µm) | 2.08 | 2.55 | 2.84 | 2.83 | 2.77 | 2.72 | 2.44 | 1.97 |
| Rt/Ry | 0.67 | 0.66 | 0.61 | 0.86 | 0.45 | 1.39 | 1.25 | 0.95 |
| σt/σy | 0.71 | 0.64 | 0.60 | 0.72 | 0.37 | 1.32 | 1.25 | 1.01 |
| Opening area rate S (%) | 99.5 | 99.7 | 98.6 | 98.4 | 99.2 | 81.1 | 99.3 | 98.6 |
| Warp yarn width opening rate Lt (%) | 70.8 | 71.0 | 63.6 | 64.4 | 82.6 | 40.1 | 47.5 | 84.0 |

(continued)

| | Example 1 | Example 2 | Example 3 | Example 4 | Example 5 | Comparative Example 1 | Comparative Example 2 | Comparative Example 3 |
|---|---|---|---|---|---|---|---|---|
| Weft yarn width opening rate Ly (%) | 98.2 | 98.9 | 96.0 | 95.6 | 95.3 | 68.5 | 98.6 | 91.6 |
| Skew evaluation | ⊙ | ⊙ | ⊙ | ○ | ⊙ | × | × | × |

It is obvious from Table 1 that the glass cloths of Examples 1 to 5 having the ratio σt/σy of the standard deviation σt of the glass strand thickness of the warp to the standard deviation σy of the glass strand thickness of the weft within a range of 0.3 to 0.9 can reduce the skew when used for the printed wiring board.

Meanwhile, it is obvious that the glass cloths of Comparative Examples 1 to 3 having the ratio σt/σy of the standard deviation σt of the glass strand thickness of the warp to the standard deviation σy of the glass strand thickness of the weft of more than 0.9 cannot reduce the skew when used for the printed wiring board.

## Claims

1. A glass cloth, comprising glass fibers as warp and weft,
wherein a ratio σt/σy of a standard deviation σt of a glass strand thickness of the warp to a standard deviation σy of a glass strand thickness of the weft of the glass cloth is within a range of 0.3 to 0.9.

2. The glass cloth according to claim 1, wherein the glass cloth has an opening area rate S within a range of 90 to 100%, wherein the opening area rate S is determined by a following expression (1) from a weaving density Wt of the warp, an average yarn width Bt of the warp, a weaving density Wy of the weft, and an average yarn width By of the weft.
(Expression 1)

$$S = \frac{\left(\frac{25000}{Wt}\right) \times \left(\frac{25000}{Wy}\right) - \left(\left(\frac{25000}{Wt}\right) - Bt\right) \times \left(\left(\frac{25000}{Wy}\right) - By\right)}{\left(\frac{25000}{Wt}\right) \times \left(\frac{25000}{Wy}\right)} \times 100 \quad \cdot\cdot\cdot(1)$$

3. The glass cloth according to claim 1, wherein the glass cloth has a ratio Rt/Ry within a range of 0.3 to 0.9, wherein Rt/Ry is a ratio of a maximum-minimum difference Rt being a difference between a maximum value and a minimum value of the glass strand thickness of the warp to a maximum-minimum difference Ry being a difference between a maximum value and a minimum value of the glass strand thickness of the weft.

4. The glass cloth according to claim 1, wherein the glass cloth has a yarn width opening rate Lt of the warp determined by a following expression (2) within a range of 60 to 83%, and has a yarn width opening rate Ly of the weft determined by a following expression (3) within a range of 85% or more.
(Expression 2)

$$Lt = \frac{Bt}{\left(\frac{25000}{Wt}\right)} \times 100 \quad \cdot\cdot\cdot(2)$$

(Expression 3)

$$Ly = \frac{By}{\left(\frac{25000}{Wy}\right)} \times 100 \quad \cdot\cdot\cdot(3)$$

5. The glass cloth according to claim 1, wherein the glass cloth has a thickness within a range of 18 to 100 $\mu$m.

6. A prepreg, comprising the glass cloth according to any one of claims 1 to 5.

7. The prepreg according to claim 6, wherein a difference between a relative dielectric constant of the glass cloth and a relative dielectric constant of a matrix resin of the prepreg is within a range of 1.5 to 3.0.

8. A printed wiring board, comprising the prepreg according to claim 6.

## INTERNATIONAL SEARCH REPORT

| International application No. |
|---|
| **PCT/JP2025/003475** |

**A. CLASSIFICATION OF SUBJECT MATTER**

*D03D 15/267*(2021.01)i; *C08J 5/24*(2006.01)i; *D03D 1/00*(2006.01)i; *H05K 1/03*(2006.01)i
FI:   D03D15/267; C08J5/24 CEZ; D03D1/00 A; H05K1/03 610T

According to International Patent Classification (IPC) or to both national classification and IPC

**B. FIELDS SEARCHED**

Minimum documentation searched (classification system followed by classification symbols)

D03D1/00-27/18; C08J5/00-5/02;5/12-5/22; H05K1/00-13/08

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2020-2520 A (ASAHI KASEI KABUSHIKI KAISHA) 09 January 2020 (2020-01-09)<br>example B5, paragraphs [0011], [0038]-[0039] | 1-8 |
| X | WO 2021/039582 A1 (NITTO BOSEKI CO., LTD.) 04 March 2021 (2021-03-04)<br>example 1, paragraphs [0033]-[0034] | 1-4, 6-8 |
| X | JP 2018-21274 A (NITTO BOSEKI CO., LTD.) 08 February 2018 (2018-02-08)<br>example 1, paragraphs [0002], [0026] | 1-4, 6-8 |
| X | JP 2017-43873 A (UNITIKA LTD.) 02 March 2017 (2017-03-02)<br>example 1, claims 8-10 | 1-4, 6-8 |
| X | WO 2019/163159 A1 (NITTO BOSEKI CO., LTD.) 29 August 2019 (2019-08-29)<br>example 1, claim 3, paragraph [0055] | 1-4, 6-8 |
| A | JP 2006-52473 A (ASAHI SCHWEBEL CO., LTD.) 23 February 2006 (2006-02-23)<br>entire text | 1-8 |

☐ Further documents are listed in the continuation of Box C.   ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **07 April 2025** | **22 April 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2025/003475**

| Patent document cited in search report | | | Publication date (day/month/year) | Patent family member(s) | | | Publication date (day/month/year) |
|---|---|---|---|---|---|---|---|
| JP | 2020-2520 | A | 09 January 2020 | US 2018/0094110 A1 example B5, paragraphs [0012], [0052]-[0053] | | | |
| WO | 2021/039582 | A1 | 04 March 2021 | US 2022/0089824 A1 example 1, paragraphs [0033]-[0034] | | | |
| JP | 2018-21274 | A | 08 February 2018 | US 2019/0153635 A1 example 1, paragraphs [0002], [0027] | | | |
| JP | 2017-43873 | A | 02 March 2017 | CN 107709642 A | | | |
| WO | 2019/163159 | A1 | 29 August 2019 | US 2020/0071858 A1 example 1, claim 3, paragraph [0056] | | | |
| JP | 2006-52473 | A | 23 February 2006 | WO 2004/020715 A1 entire text | | | |

Form PCT/ISA/210 (patent family annex) (July 2022)

**EP 4 782 583 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006232952 A